# EUROPEAN PATENT APPLICATION

(11) **EP 3 882 211 A1**
(43) Date of publication of application: **22.09.2021**
(21) Application number: 19885582.7
(22) Date of filing: 15.11.2019
(51) Int. Cl.: B81B 3/00, B81C 1/00, H02N 1/00

(54) **METHOD FOR MANUFACTURING COMB-TOOTHED ELEMENT**

(30) Priority: 16.11.2018 JP 2018215631
(71) Applicant: The University of Tokyo, Bunkyo-ku Tokyo 113-8654 (JP); Saginomiya Seisakusho, Inc., Tokyo 165-0033 (JP)
(72) Inventor: TOSHIYOSHI, Hiroshi, Tokyo 113-8654 (JP); HONMA, Hiroaki, Tokyo 113-8654 (JP); MITSUYA, Hiroyuki, Sayama-shi, Saitama 350-1395 (JP)
(74) Representative: V.O.
(86) International application number: PCT/JP2019/044861
(87) International publication number: WO 2020/101015

(57) **Abstract**

A manufacturing method of a comb tooth element that has a plurality of fixed comb teeth and a plurality of movable comb teeth arranged to interdigitate with each other through a clearance, wherein an interdigitating amount of the movable comb teeth with respect to the fixed comb teeth is variable, comprises: forming first patterned masks for forming the fixed comb teeth and second patterned masks for forming the movable comb teeth on a surface of a base material to be etched; forming patterned masks to be etched, that are arranged on the base material to be etched between adjacent first patterned masks and between adjacent second patterned masks and have a thickness based on a first gap dimension between the fixed comb tooth and the movable comb tooth adjacent to one another and a second gap dimension between the fixed comb teeth adjacent to each other; and forming the fixed comb teeth and the movable comb teeth by etching with Deep-RIE the base material to be etched and the patterned masks to be etched.

## Description

### TECHNICAL FIELD

The present invention relates to a manufacturing method of a comb tooth element.

### BACKGROUND ART

Conventionally, an electrostatic type minute vibration-driven energy harvesting element using a MEMS processing technique is known. Patent Literature 1 (PTL 1) describes a vibration-driven energy harvesting element in which fixed side comb tooth electrodes and movable side comb tooth electrodes are arranged so as to interdigitate with each other, and power is generated as the insertion amount of the comb tooth electrodes changes due to vibration. The vibration-driven energy harvesting element described in PTL 1 has a three-terminal structure including a pair of fixed side electrodes and one movable side electrode that vibrates between the pair of fixed side electrodes, so that it is possible to generate power efficiently even if the external vibration is small.

### CITATION LIST

### PATENT LITERATURE

PTL 1: Japanese Laid-Open Patent Publication No. 2018-88780

### SUMMARY OF INVENTION

### TECHNICAL PROBLEM

As an example of a technique of increasing the generated power of the vibration-driven energy harvesting element described in PTL 1, a surface area of the comb tooth electrodes may be increased by enlarging a height dimension of the comb teeth. However, in a comb tooth element having a structure in which fixed comb teeth and movable comb teeth interdigitate with each other through a clearance, an aspect ratio of a gap region of an interdigitated portion is several times larger than an aspect ratio of a gap region of a non-interdigitated comb tooth root portion. The vibration-driven energy harvesting element is formed by processing a Si substrate or the like using MEMS processing technology. Therefore, when processing regions having different aspect ratios as described above by etching, there is a problem that accurate processing cannot be performed due to the influence by a difference in etching rates.

### SOLUTION TO PROBLEM

According to a 1st aspect of the present invention, a manufacturing method of a comb tooth element that has a plurality of fixed comb teeth and a plurality of movable comb teeth arranged to interdigitate with each other through a clearance, wherein an interdigitating amount of the movable comb teeth with respect to the fixed comb teeth is variable, comprises: forming first patterned masks for forming the fixed comb teeth and second patterned masks for forming the movable comb teeth on a surface of a base material to be etched; forming patterned masks to be etched, that are arranged on the base material to be etched between adjacent first patterned masks and between adjacent second patterned masks and have a thickness based on a first gap dimension between the fixed comb tooth and the movable comb tooth adjacent to one another and a second gap dimension between the fixed comb teeth adjacent to each other; and forming the fixed comb teeth and the movable comb teeth by etching with Deep-RIE the base material to be etched and the patterned masks to be etched.

According to a 2nd aspect of the present invention, in the manufacturing method of a comb tooth element according to the 1st aspect, it is preferable that the thickness of the patterned masks to be etched is calculated by a formula of (1 / Re1 - 1 / Re2) × Rer × L, where: Re1 is an etching rate for etching the base material to be etched with the Deep-RIE through an opening having an opening width of the first gap dimension; Re2 is an etching rate for etching the base material to be etched with the Deep-RIE through an opening having an opening width of the second gap dimension; Rer is an etching rate for etching the patterned masks to be etched with the Deep-RIE through an opening having an opening width of the second gap dimension; and L is a comb tooth height of the fixed comb teeth and the movable comb teeth.

According to a 3rd aspect of the present invention, in the manufacturing method of a comb tooth element according to the 1st or the 2nd aspect, it is preferable to further comprise: after forming the fixed comb teeth and the movable comb teeth by etching with the Deep-RIE, forming an electret at least either at the fixed comb teeth or at the movable comb teeth.

According to a 4th aspect of the present invention, in the manufacturing method of a comb tooth element according to the 3rd aspect, it is preferable to further comprise: after forming the electret, forming an electret protective film on a surface of the electret.

### ADVANTAGEOUS EFFECTS OF INVENTION

According to the present invention, it is possible to improve the processing accuracy of the comb tooth element.

### BRIEF DESCRIPTION OF DRAWINGS

[Fig. 1] Fig. 1 is a plan view of a vibration-driven energy harvesting element.
[Fig. 2] Fig. 2 is a diagram showing a shape of a fixed portion and a BOX layer (SiO₂ layer) on the fixed portion.
[Fig. 3] Fig. 3 is a diagram illustrating an electret formed at comb tooth electrodes.
[Fig. 4] Fig. 4 shows diagrams explaining the principle of vibration-driven energy harvesting.
[Fig. 5] Fig. 5 is an enlarged view of a portion of the comb tooth electrodes that interdigitate with each other.
[Fig. 6] Fig. 6 is a graph showing an example of measured values of an etching rate.
[Fig. 7] Fig. 7 shows diagrams schematically showing a shape of etching grooves.
[Fig. 8] Fig. 8 shows diagrams showing a procedure for forming the comb tooth electrode portion.
[Fig. 9] Fig. 9 shows diagrams showing a procedure subsequent of the procedure shown in Fig. 8.
[Fig. 10] Fig. 10 shows diagrams explaining a third step.
[Fig. 11] Fig. 11 shows diagrams explaining the third step subsequent to the procedure shown in Fig. 10.
[Fig. 12] Fig. 12 shows diagrams illustrating a variation of a dummy pattern, in which a second step is shown.
[Fig. 13] Fig. 13 shows diagrams illustrating an aspect ratio in a case where dimensions of a fixed side comb tooth electrode and a movable side comb tooth electrode are different from one another in the comb tooth height direction.
[Fig. 14] Fig. 14 is a graph showing an example of the relationship between the comb tooth aspect ratio at the time of maximum displacement and the generated power.

### DESCRIPTION OF EMBODIMENTS

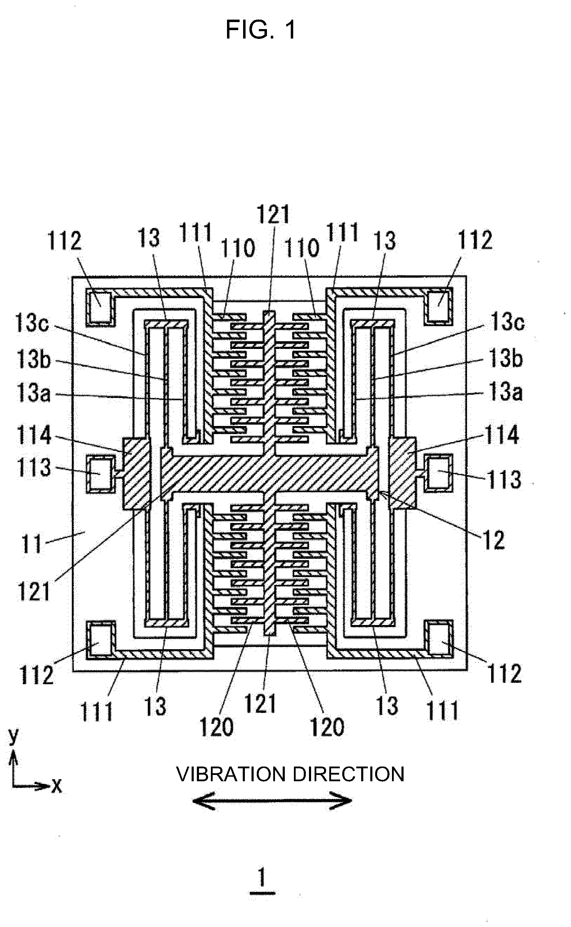

Hereinafter, embodiments for carrying out the present invention will be described with reference to the drawings. Fig. 1 is a plan view of a vibration-driven energy harvesting element 1, showing an example of a comb tooth element. The vibration-driven energy harvesting element 1 includes a fixed portion 11 provided with a fixed electrode portion 111, a movable portion 12 provided with a movable electrode portion 121, and an elastic support portion 13 elastically supporting the movable portion 12. The movable portion 12 is mechanically and electrically connected to a connecting portion 114 formed on the fixed portion 11 via the elastic support portion 13.

The vibration-driven energy harvesting element 1 shown in Fig. 1 is formed by a commonly used MEMS processing technique using an SOI (Silicon on Insulator) substrate. The SOI substrate is a substrate having a three-layer structure composed of a handle layer of Si, a BOX layer of SiO₂, and a device layer of Si. The fixed portion 11 is formed of the handle layer, and the fixed electrode portion 111, the movable portion 12, the elastic support portion 13, and the connecting portion 114 are formed of the device layer. It is to be noted, the vibration-driven energy harvesting element 1 is not limited to be formed by the SOI substrate and may be formed by using a Si substrate or the like.

Four sets of fixed electrode portions 111 are formed on the fixed portion 11, and a plurality of comb tooth electrodes 110, each extending in the x direction, are arranged in the y direction in each fixed electrode portion 111. In the movable portion 12, two sets of movable electrode portions 121 are formed at the upper side and the lower side of the drawing. A plurality of comb tooth electrodes 120, each extending in the x direction, are arranged in the y direction in each movable electrode portion 121. The comb tooth electrodes 110 of the fixed electrode portion 111 and the comb tooth electrodes 120 of the movable electrode portion 121 are arranged so as to interdigitate with each other with a predetermined interdigitating length in the x direction through a gap, in a stationary state.

The movable portion 12 is elastically supported by four sets of the elastic support portions 13. Each elastic support portion 13 includes three elastically-deformable beams 13a to 13c. An end of the beam 13a is fixed on the fixed portion 11, an end of the beam 13b is connected to either end of the movable electrode portion 12 in the x direction, and an end of the beam 13c is connected to the connecting portion 114 formed on the fixed portion 11. An electrode pad 112 is formed on the fixed electrode portion 111, and an electrode pad 113 is formed on the connecting portion 114. When the movable portion 12 vibrates in the x direction, the movable electrode portion 121 vibrates between the pair of fixed electrode portions 111, and thereby, the insertion amount (interdigitating amount) of the comb tooth electrode 120 with respect to the comb tooth electrode 110 of the fixed electrode portion 111 changes and power is generated.

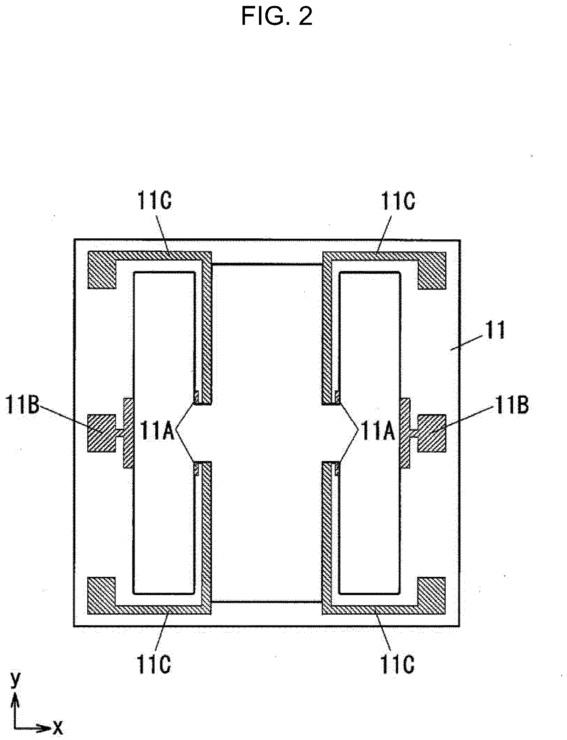

Fig. 2 shows, in a plan view, a shape of the fixed portion 11 formed in the handle layer of the SOI substrate and a shape of fixed portion regions 11A, 11B, 11C formed in the BOX layer and shown by hatching. The fixed portion regions 11A, 11B, and 11C are remaining parts of the BOX layer present between the fixed electrode portion 111, the connecting portion 114, and the elastic support portion 13 formed in the device layer and the fixed portion 11. The fixed portion region 11A is a BOX layer present between the end of the beam 13a and the fixed portion 11. The fixed portion region 11B is a BOX layer present between the connecting portion 114 and the fixed portion 11. The fixed portion region 11C is a BOX layer present between the fixed electrode portion 111 and the fixed portion 11.

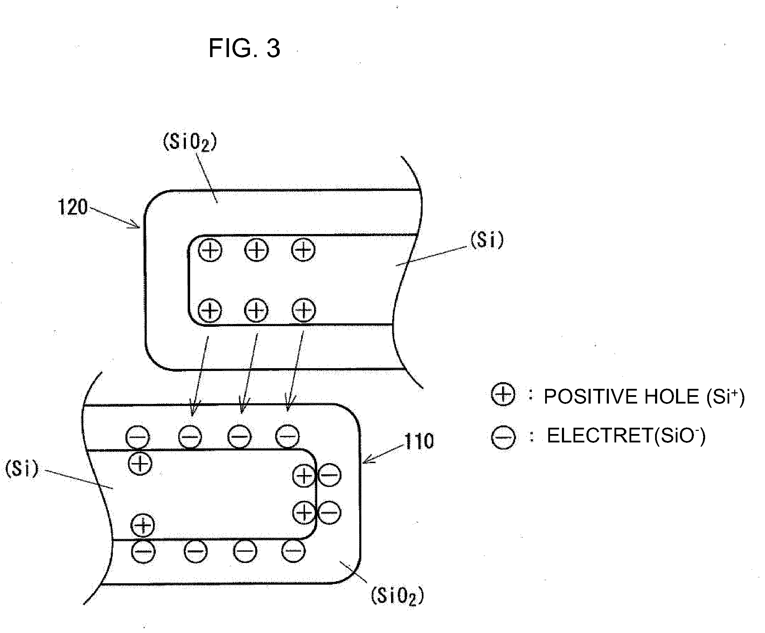

Fig. 3 is a schematic view showing a partial cross section of the comb tooth electrode 110 of the fixed electrode portion 111 and the comb tooth electrode 120 of the movable electrode portion 121. An electret is formed at the comb tooth electrodes 110 and 120 by a well-known B-T method (Bias-Temperature method: see, for example, Japanese Laid-Open Patent Publication No. 2013-13256). In the example shown in Fig. 3, a negative charged (SiO⁻) electret is formed in an oxide film (SiO₂ film) formed at the surface of the comb tooth electrode 110. Arrows indicate lines of electric force.

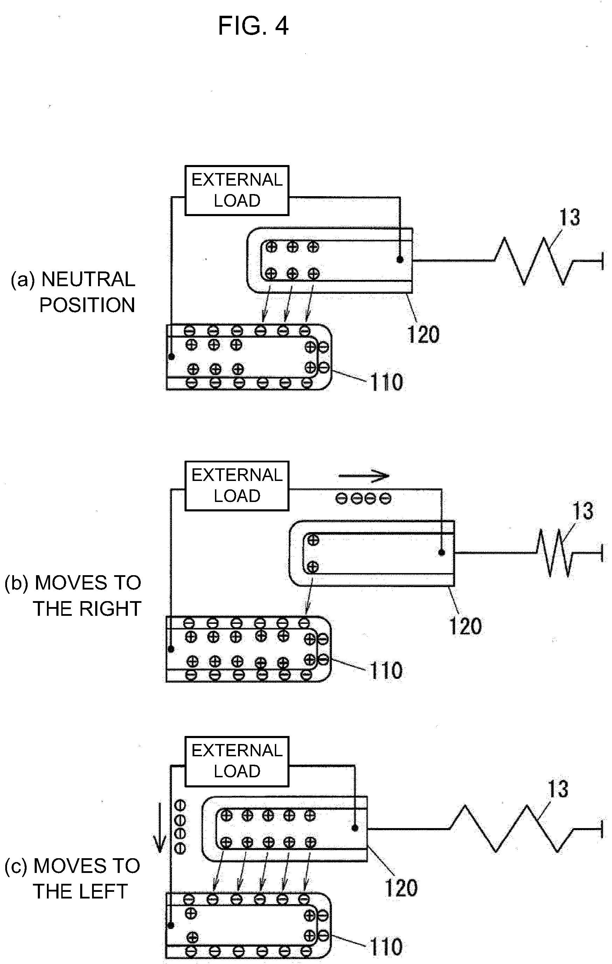

Fig. 4 shows diagrams explaining the principle of vibration-driven energy harvesting. It is to be noted that in Fig. 4, a two-terminal structure in which one movable electrode portion is provided for one fixed electrode portion is shown as an example. Fig. 4 (a) shows the comb tooth electrodes 110 and 120 in a case where the movable electrode portion 121 (not shown) is located at a neutral position where the electrostatic force of the electret and the elastic force of the elastic support portion 13 are balanced with each other. As the comb tooth electrode 120 on the movable electrode portion side moves to the right as shown in Fig. 4 (b) from the state of Fig. 4 (a) due to environmental vibration, the interdigitating region between the comb tooth electrode 110 and the comb tooth electrode 120 becomes smaller. As a result, electrostatically induced electrons flow from the comb tooth electrode 110 to the comb tooth electrode 120. On the contrary, as the comb tooth electrode 120 on the movable electrode portion side moves to the left as shown in Fig. 4 (c) from the state of Fig. 4 (a), the interdigitating region between the comb tooth electrode 110 and the comb tooth electrode 120 becomes larger. As a result, electrostatically induced electrons flow from the comb tooth electrode 120 to the comb tooth electrode 110.

In such a vibration-driven energy harvesting element that generates power by changing the insertion amount (interdigitating amount) of the comb tooth electrodes at which the electrets are formed, as the height of the facing surfaces (side walls) of the comb tooth electrodes 110 and 120 interdigitating with each other is larger, the larger amount of power is generated with the same vibration amount. That is, the thicker device layer of the SOI substrate at which the comb tooth electrodes 110 and 120 are formed allows the side wall areas of the comb tooth electrodes 110 and 120 to be larger. As a result, it is possible to provide a vibration-driven energy harvesting element which generates a larger amount of power even if the area of the element in the plan view in Fig. 1 remains the same.

In the vibration-driven energy harvesting element 1 at which the electret is formed, the comb tooth electrode 120 of the movable electrode portion 121 is drawn toward the comb tooth electrode 110 of the fixed electrode portion 111 due to the electrostatic attraction force by the electret. In a case where the elastic force due to the deformation of the elastic support portion 13 is relatively large, the electrostatic force and the elastic force stay in balance in a state that the comb tooth electrode 120 is drawn in halfway. In a case where the elastic force of the elastic support portion 13 is smaller than the electrostatic force, the electrostatic force and the elastic force are not balanced with each other, and the comb tooth electrode 120 is completely drawn in. Therefore, in a vibration-driven energy harvesting element having a two-terminal configuration as shown in Fig. 4, if the electrostatic force is increased due to the larger dimension (z direction dimension) of the comb tooth electrodes 110 and 120 in the thickness direction of the device layer, there arises a problem that the vibration does not readily occur with the small environmental vibration.

In the present embodiment, by adopting a three-terminal configuration in which the movable electrode portion 121 vibrates between the pair of fixed electrode portions 111, the vibration-driven energy harvesting element 1 is configured to have the three-terminal configuration in which the electrostatic attraction generated by one of the comb tooth electrodes 110 and 120 cancels the electrostatic attraction generated by the other of the comb tooth electrodes 110 and 120. Furthermore, by adopting the three-terminal configuration, it is possible to increase the size of the comb tooth electrodes 110 and 120 in the comb tooth height direction, that is, the dimension in the z direction without taking account of an influence of the electrostatic attraction, and therefore, increase in the amount of power generation is facilitated without increasing the number of comb teeth. The amount of power generation can also be increased by increasing the number of comb teeth while sustaining the z-direction dimension of the comb tooth electrodes as it is, however in such a case, there is a drawback that the plan view area of the vibration-driven energy harvesting element 1 increases, causing the vibration-driven energy harvesting element 1 to become bulky.

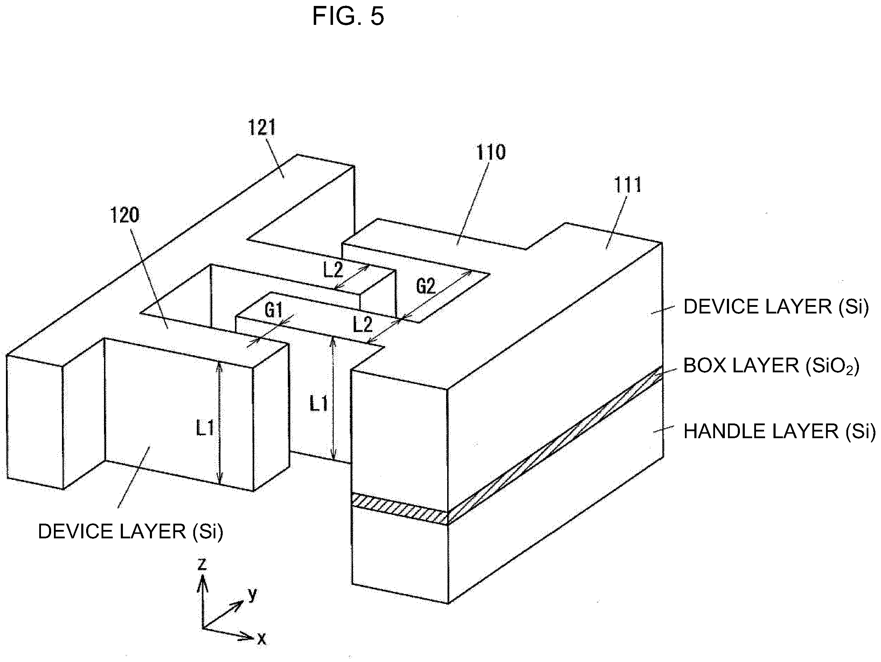

In the vibration-driven energy harvesting element 1 provided with the comb tooth electrodes 110 and 120 that interdigitate with each other, the gap size of the portion where the comb tooth electrode 120 is inserted between the comb tooth electrodes 110, that is, the gap dimension G1 between the comb tooth electrodes 110 and 120 in an interdigitated state as shown in Fig. 5, is smaller than the gap size G2 of a non-interdigitated portion between the adjacent comb tooth electrodes 110. The z-direction dimension L1 of the comb tooth electrodes 110 and 120 is generally the same as the thickness dimension of the device layer of the SOI substrate. L2 is the y-direction dimension of the comb tooth electrodes 110 and 120.

Regarding a clearance region (hereinafter, also referred to as a gap region) between the comb tooth electrodes 110 and 120, the ratio L1 / G1 of the dimension L1 of the gap region in the comb tooth height direction to the gap dimension G1 of the gap region is referred to as an aspect ratio. Similarly, in the comb tooth electrodes 110 near the roots of the comb teeth, the aspect ratio of the gap region between the adjacent comb tooth electrodes 110 at a non-interdigitated portion is represented by L1 / G2. As an example, in the case of G1 = 9 µm, L1 = 300 µm, and L2 = 20 µm, then G2 = 38 µm, and in such a case the aspect ratio of the gap region between the comb tooth electrodes 110 and 120 is 33.3 and the aspect ratio of the gap region between the adjacent comb tooth electrodes 110 is 7.9.

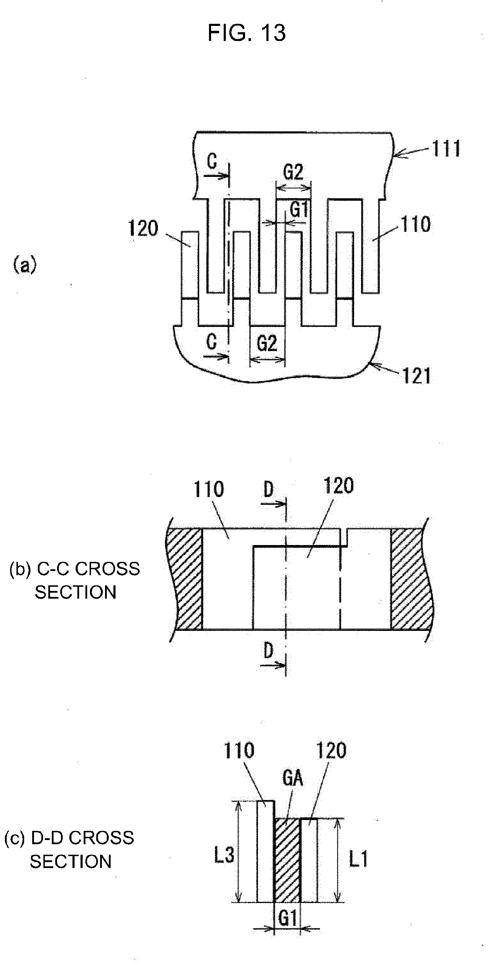

It is to be noted, as shown in Fig. 13, in a case where the dimension L3 of the fixed side comb tooth electrode 110 in the comb tooth height direction is different from the dimension L1 of the movable side comb tooth electrode 120 as L1 < L3, a clearance region GA is a region sandwiched between the comb tooth electrode 110 and the comb tooth electrode 120, and the dimension of the clearance region GAin the comb tooth height direction is L1. With respect to Fig. 13, (a) is a plan view of the comb tooth electrodes 110 and 120, (b) is a C-C cross sectional view, and (c) is a D-D cross sectional view. The aspect ratio of the clearance region GAis represented as L1 / G1. On the other hand, in a case where L3 < L1, the dimension of the clearance region GA in the comb tooth height direction is L3, and the aspect ratio is expressed as L3 / G1.

In the vibration-driven energy harvesting element 1 of the present embodiment, the comb tooth electrode 110 of the fixed electrode portion 111 and the comb tooth electrode 120 of the movable electrode portion 121 are interdigitated with each other and vibration occurs in the insertion direction. In such a structure, the gap dimension G1 of the portion in the interdigitated state differs from the gap dimension G2 of the portion in the non-interdigitated state. The vibration-driven energy harvesting element 1 is formed by processing an SOI substrate by semiconductor processing technology, and grooves having a large aspect ratio such as the gap regions of the comb tooth electrodes 110 and 120 are usually processed by Deep-RIE.

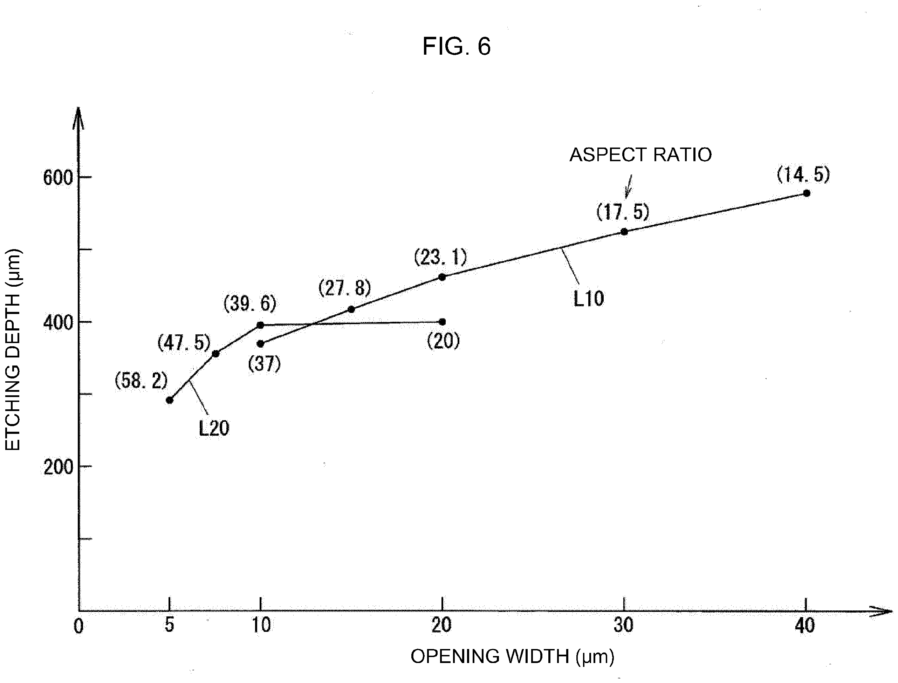

The etching rate in the Deep-RIE depends on the gap dimension (groove width). Fig. 6 is a graph showing an example of measured values of an etching rate. The line L10 shows etching depth for the grooves having opening widths from 10 µm to 30 µm when the etching depth of the groove having an opening width of 40 µm reaches 578.6 µm after simultaneously starting etching of the grooves having the opening widths of 10 µm, 15 µm, 20 µm, 30 µm, and 40 µm. Further, the line L20 shows etching depth for the grooves having opening widths from 5 µm to 10 µm when the etching depth of the groove having an opening width of 20 µm reaches 400 µm after simultaneously starting etching of the grooves having opening widths of 5 µm, 7.5 µm, 10 µm, and 20 µm.

The aspect ratios for the opening widths of 10 µm, 15 µm, 20 µm, 30 µm, and 40 µm on the line L10 are 37, 27.8, 23.1, 17.5, and 14.5, respectively. Further, the aspect ratios for the opening widths of 5 µm, 7.5 µm, 10 µm, and 20 µm on the line L20 are 58.2, 47.5, 39.6, and 20, respectively.

Comparing the lines L10 and L20, a degree of change of the etching rate with respect to the opening width changes around the opening width of approximately 10 to 20 µm. That is, it is presumed that a degree of decrease in the etching rate gradually increases from around the opening width of 20 µm, and further, as the opening width becomes smaller than approximately 10 µm and the aspect ratio becomes larger than 30, a degree of decrease in the etching rate becomes more remarkable. It has been found that in a case where gap regions having different aspect ratios coexist as shown in Fig. 5, the etching rates in the gap regions having different aspect ratios differ greatly from one another, which adversely affects the shape of the comb teeth formed by the etching process.

For example, a ratio of the etching rate for the opening width of 5 µm to the etching rate for the opening width of 20 µm is smaller than a ratio of the etching rate for the opening width of 20 µm and the etching rate for the opening width of 40 µm. Therefore, for etching the device layer of the SOI substrate up to the BOX layer, the time difference between the etching times required to etch the opening width of 5 µm and the opening width of 20 µm until the BOX layer, is greater than the time difference between the etching times required to etch the opening width of 20 µm and the opening width of 40 µm until the BOX layer. If the etching time difference is large, a groove side wall near the BOX layer is further etched in an etching groove having a larger opening width that has reached the BOX layer earlier. As a result, the wall thickness, that is, the width dimension of the comb tooth electrode becomes smaller, and it adversely affects vibration-driven energy harvesting. Such an influence on the thickness of the groove side wall becomes more remarkable as the distance up to the BOX layer becomes larger, and in a case where the aspect ratio of the gap region of the gap dimension G1 is 20 or more, it may affect the vibration-driven energy harvesting.

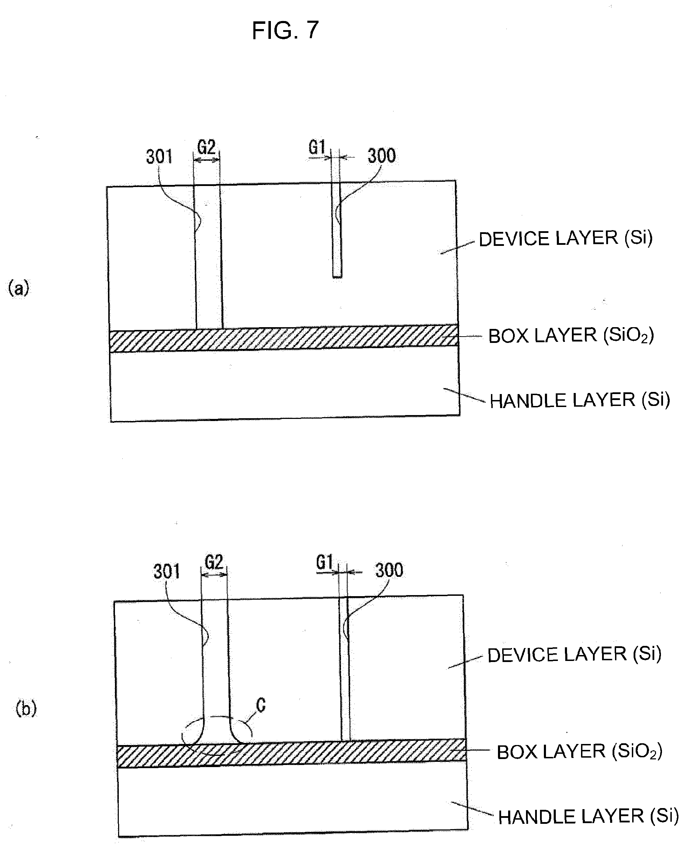

Fig. 7 shows diagrams schematically showing etching groove shapes when forming a groove 300 having a gap dimension G1 and a groove 301 having a gap dimension G2 (> G1) in the device layer of the SOI substrate. Fig. 7 (a) shows the shape of the groove 301 having the gap dimension G2 upon reaching the BOX layer and the shape of the groove 300 having a narrower groove width which has not yet reached the BOX layer. Fig. 7 (b) shows the shape of the groove 300 upon reaching the BOX layer. From the state of Fig. 7 (a) to the state of Fig. 7 (b), the device layer tends to be etched in the lateral direction near the bottom of the groove 301 (near the BOX layer). When the groove 300 has reached the BOX layer as shown in Fig. 7 (b), the groove 301 has a shape in which the groove wall portion is etched to be a notch shape in a region C near the BOX layer.

### Comb tooth Electrode Forming Method

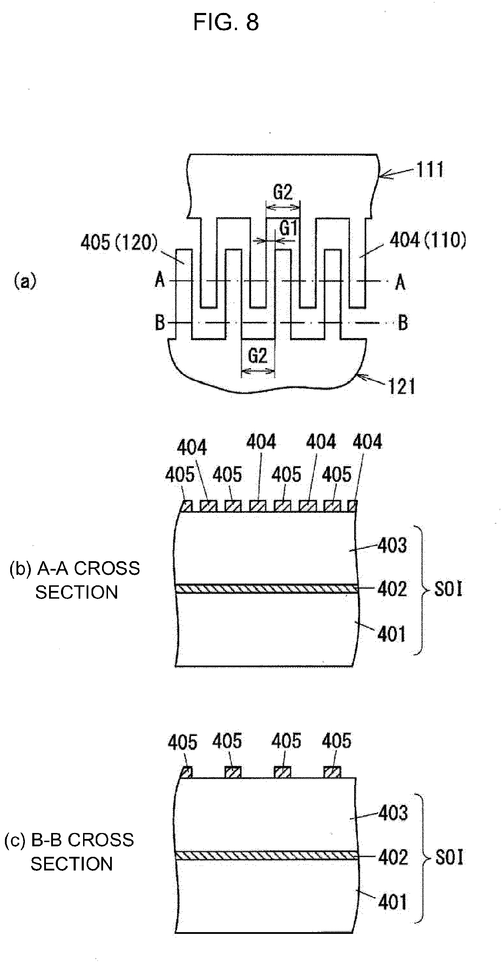

In the present embodiment, in order to prevent from etching into a notch shape as shown in Fig. 7 (b), a mask form for forming the comb tooth electrodes different from the conventional one is employed. Because the method of forming the structure body of the vibration-driven energy harvesting element 1 using the SOI substrate is the same as the conventional forming method (for example, refer to WO2015 / 019919 and the like) except for the mask form of the comb tooth electrode portion, only the procedure for forming the comb tooth electrodes 110 and 120 in the structure body will be described hereinafter. Figs. 8 to 11 are diagrams showing a procedure for forming the comb tooth electrodes 110 and 120. Fig. 8 (a) is a plan view of portions of the comb tooth electrodes 110 and 120, and Figs. 8 (b) and 8 (c) show an A-A cross-sectional view and a B-B cross-sectional view, respectively.

In a first step, an SOI substrate composed of a handle layer 401, a BOX layer 402, and a device layer 403 is prepared, and patterned aluminum masks 404 and 405 for forming the comb tooth electrodes 110 and 120 are formed on the surface of the device layer 403 in shapes as shown in Figs. 8(a) to 8(c). The plan view shape of the patterned aluminum masks 404 corresponds to the plan view shape of the comb tooth electrodes 110, and the plan view shape of the patterned aluminum masks 405 corresponds to the plan view shape of the comb tooth electrodes 120. The A-A cross sectional view (Fig. 8 (b)) shows that, in the interdigitated state region, the patterned aluminum masks 404 and 405 are formed, and the B-B cross sectional view (Fig. 8 (c)) shows that, in a non-interdigitated root region of the comb tooth electrodes 120, only the patterned aluminum masks 405 are formed. The distance (opening width) G2 between the patterned aluminum masks 405 shown in Fig. 8 (c) is wider than the distance (opening width) G1 between the patterned aluminum mask 404 and the patterned aluminum mask 405 shown in Fig. 8 (b). As shown in Fig. 8 (a), the distance between the patterned aluminum masks 404 is also G2.

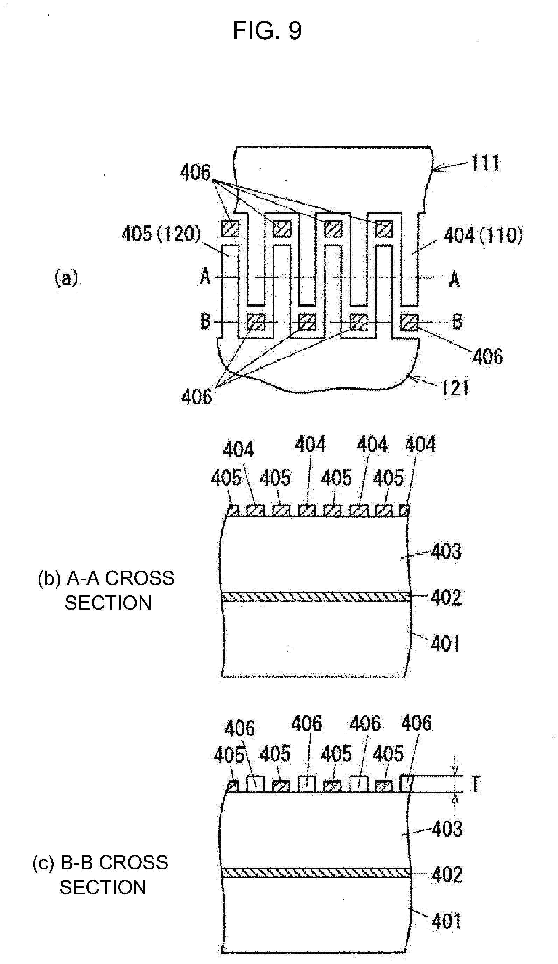

Fig. 9 shows diagrams showing a second step. In the second step, as shown in a plan view of Fig. 9 (a), a patterned dummy 406 of a resist is formed, in each space between the adjacent patterned aluminum masks 405 and between the adjacent patterned aluminum masks 404, at the comb teeth root region. The patterned dummies 406 are arranged in a pattern for adjusting the etching completion timings (timings to reach the BOX layer) of a groove having a narrower opening width and a groove having a wider opening width to be almost the same as one another, and at the end of the groove processing (at the completion of forming of the comb tooth electrodes) by the Deep-RIE, the pattered dummies 406 are removed by etching. The method of setting the thickness T of the patterned dummies 406 will be described later.

While a resist is used here as a material of the patterned dummies 406, any materials other than the resist can also be used as long as its etching rate by the Deep-RIE is larger than that of the patterned aluminum masks and it can be removed at the end of the etching process. Here, as shown in Fig. 9 (a), a case where a distance between the patterned dummy 406 and the patterned aluminum mask 404, 405 is set to be substantially equal to a distance between the adjacent aluminum mask patterns 404, 405 in an interdigitated state will be described.

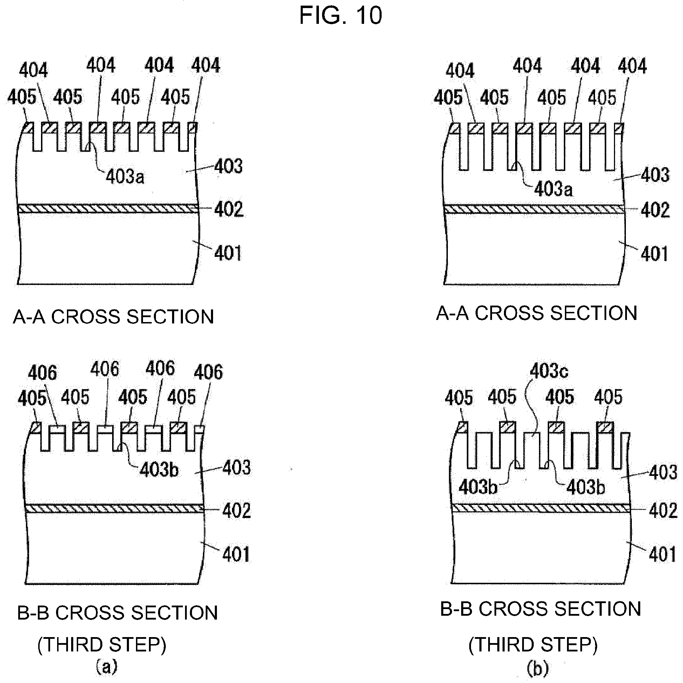

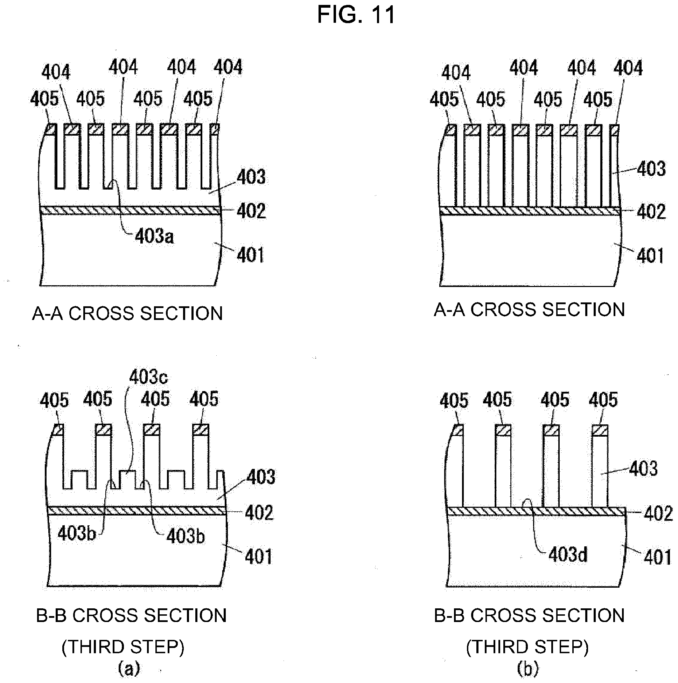

Figs. 10 and 11 are diagrams showing a third step. In the third step, etching by the Deep-RIE is performed to form the comb tooth electrodes 110 and 120 at the device layer 403. The etching proceeds in the order of Fig. 10 (a), Fig. 10 (b), Fig. 11 (a), and Fig. 11 (b), and at the state shown in Fig. 11 (b), the etching step (the third step) is completed. The A-A cross-sectional view of Fig. 10 (a) shows that exposed portions of the device layer 403 without being covered with the patterned aluminum masks 404 and 405 are etched to be dug down, and grooves 403a are being formed. On the other hand, the B-B cross sectional view shows that exposed portions of the device layer 403 between the patterned dummies 406 and the patterned aluminum masks 405 are etched to form grooves 403b, and the patterned dummies 406 of the resist are also etched and the thickness thereof decreases.

Fig. 10 (b) shows a state at which the etching time has further elapsed from Fig. 10 (a) and the thickness of the patterned dummies 406 has become zero by etching as shown in a B-B cross sectional view. The depths of the grooves 403a and 403b are increased as compared with the state shown in Fig. 10 (a). As shown in the B-B cross sectional view, the device layer 403 exposed between the adjacent patterned aluminum masks 405 has a cross-sectional shape in which the grooves 403b are formed on both sides of a convex portion 403c.

Fig. 11 (a) shows a state at which the etching time has further elapsed from Fig. 10 (b). The depths of the grooves 403a and 403b are further increased, and as shown in a B-B cross sectional view, the convex portions 403c are also etched so that a tip position thereof becomes lower than in the state of Fig. 10 (b). In the B-B cross sectional view, as the distance between the adjacent patterned aluminum masks 405 (that is, the opening width) is wider than the distance between the patterned aluminum mask 404 and 405 in a A-A cross sectional view, its etching rate is greater. Therefore, a rate of lowering the tip position of the convex portions 403c is greater than a rate of increase in the depth of the grooves 403a.

Fig. 11 (b) shows a state when the grooves 403a in a A-A cross sectional view have reached the BOX layer 402 after further elapsing the etching time from Fig. 11 (a). The grooves 403b shown in Fig. 11 (a) have reached the BOX layer 402 almost at the same time as the grooves 403a in the A-A cross sectional view, as shown in a B-B cross sectional view in Fig. 11 (b). Further, the convex portions 403c shown in Fig. 11 (a) are also completely removed by etching almost at the same time when the grooves 403a have reached the BOX layer 402. As a result, a groove 403d having a wider groove width is formed between the adjacent patterned aluminum masks 405.

After that, the structure body of the vibration-driven energy harvesting element 1 is formed through a step of releasing from the BOX layer by BHF (buffered hydrofluoric acid) or the like. As described above, while the patterned dummies 406 are removed by the Deep-RIE as described above, a protective film for the Deep-RIE may remain around the patterned dummies 406. However, the protective film is also released and removed in the releasing process from the BOX layer.

After forming the structure body of the vibration-driven energy harvesting element 1, electret films are formed at the comb tooth electrodes 110 and 120 by a well-known B-T method. Further, in order to improve the stability (moisture resistance) of the electret, a protective film may be formed on surfaces of the electret films. Among various types of protective films, for example, an aluminum oxide film formed by a well-known Atomic Layer Deposition (ALD) method is preferable. Although the explanation of the method for forming the aluminum oxide film by the ALD method is omitted herein, it can be formed by a well-known manufacturing method such as that described in Japanese Laid-Open Patent Publication No. 2016-82836. By using the ALD method, it is possible to achieve a uniform film forming property even on a surface of a structure body having a large aspect ratio such as in the gap region of the comb tooth electrodes according to the present embodiment, and to improve the charge stability of the electret.

The thickness of the patterned dummy 406 may be set as follows, for example. First, patterned aluminum masks having an opening of a gap dimension G1 and an opening having a gap dimension G2 (> G1) are formed on a Si substrate that is equivalent to the device layer 403. Next, by performing etching by the Deep-RIE, a time t2 (min) until an etching groove depth of the opening having the gap dimension G2 reaches a desired depth H is measured. By further performing etching, a time t1 (min) until an etching groove depth of the opening having the gap dimension G1 reaches the desired depth H is measured. Next, an etching rate (etching speed) Rer (µm / min) of the resist used for the patterned dummy 406 is determined. It is to be noted, a width (gap dimension) of the opening for etching the resist is set to be the gap dimension G2. As shown in Fig. 5, in a case where the comb tooth height (dimension in the z direction), that is, the thickness of the device layer 403 is L1, the thickness T required for the patterned dummy 406 is calculated as T = (t1 - t2) · Rer · (L1 / H).

Further, with the desired depth being H (µm), the etching rate Re1 when etching the Si substrate through the opening of the gap dimension G1 is expressed as Re1 = H / t1, and the etching rate Re2 when etching the Si substrate through the opening of the gap dimension G2 is expressed as Re2 = H / t2. Therefore, by using the etching rates Re1 and Re2, the thickness T required for the patterned dummy 406 is calculated as T = (1 / Re1 - 1 / Re2) × Rer × L1.

As described above, in the present embodiment, in a case where openings having different gap dimensions are present as shown in Fig. 8, the patterned dummies 406 are arranged in the openings having a larger gap dimension as shown in Fig. 9 (a). Thereby, the etching can reach the BOX layer 402, which is the etching stop layer, at substantially the same timing in a portion where the gap dimension G1 is small and the aspect ratio is large as in the region where the comb tooth electrodes 110 and 120 are interdigitated with each other, and in a portion where the gap dimension G2 is large and the aspect ratio is small as in the root region of the comb tooth electrodes 110 and 120, as shown in Fig. 11 (b). As a result, it is possible to prevent the groove wall portion from being etched in a notch shape, as shown by the sign C in Fig. 7 (b), in the root region (gap dimension G2) of the comb tooth electrodes 110 and 120, and thereby it is possible to form a comb tooth electrode having a desired shape.

### Variation of Patterned Dummy 406

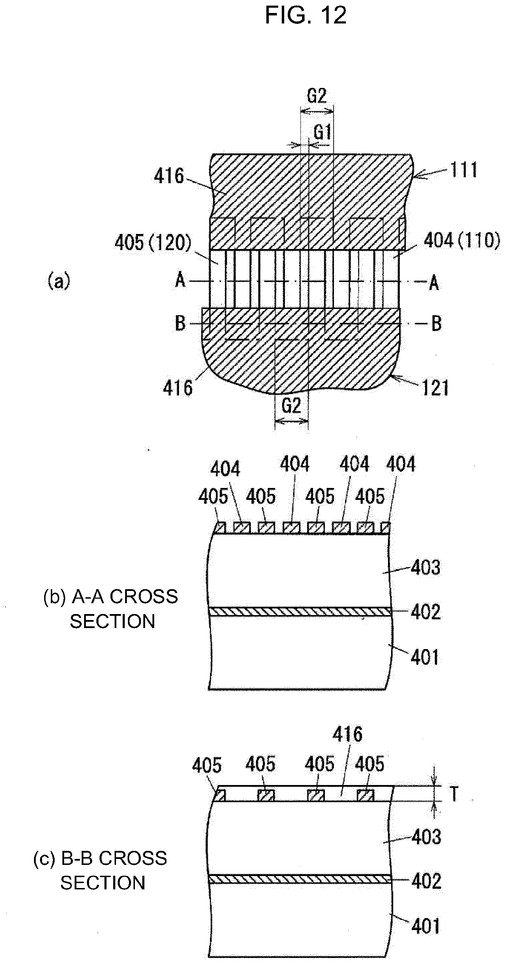

In the example shown in Fig. 9 (a) described above, the patterned dummies 406 are arranged at intervals between the adjacent patterned aluminum masks 405, however an arrangement example of the patterned dummies 406 is not limited to this. For example, instead of the patterned dummies 406 described above, a dummy mask 416 may be formed as shown in Fig 12. In Fig. 12 also, similarly to Fig. 9, (a) is a plan view, (b) is an A-A cross sectional view, and (c) is a B-B cross sectional view.

The dummy mask 416 is not formed in the comb tooth region having the gap dimension of G1 so that the A-A cross sectional view in Fig. 12 (b) is the same as that in Fig. 9 (b). On the other hand, in the comb tooth portion having the gap dimension G2, the dummy mask 416 of a resist is formed so as to cover not only the openings but also the patterned aluminum masks 404 and 405. As shown in the B-B cross sectional view in Fig. 12 (c), the dummy mask 416 is formed so that its thickness T at the opening portion is the same as the thickness T of the patterned dummy 406 shown in Fig. 9 (c).

Even in a case where such a dummy mask 416 is formed, the etching of the gap region having the gap dimension G1 and the etching of the gap region having the gap dimension G2 can reach the BOX layer 402 at substantially the same timing. However, in the case of this variation, an unnecessary protective film may remain at the comb teeth portion as a residue having a shape like a protrusion even after the Deep-RIE is performed, causing the movable side comb tooth electrode 120 to be locked to the fixed side comb tooth electrode 110. Furthermore, if an attempt is made to remove the protective film remaining after etching with BHF in the above releasing process, there is a risk that the shape of the comb tooth portion may be deformed or the comb tooth portion may be removed by the release process due to excessive etching.

As described above, in the present embodiment and the variation, by arranging the patterned dummies 406 or the dummy mask 416 in the opening region having a wider opening width of the gap dimension G2, the etching completion timings for the gap dimension G2 and the smaller gap dimension G1 can be substantially the same as each other. As a result, in the vibration-driven energy harvesting element having a structure in which the fixed side and movable side comb tooth electrodes interdigitate with each other, a comb teeth structure having a large aspect ratio in the gap region can be formed in an accurate shape. Although a cleaning step or an O₂ ashing step for removing the protective film after the Deep-RIE is additionally practically required, side walls that face each other in the side walls of the pair of comb tooth electrodes 110 of the fixed electrode portion 111, can be formed as vertical walls from the BOX layer to the surface of the handle layer. The same applies to the pair of comb tooth electrodes 120 of the movable electrode portion 121, and the side walls facing each other can be formed as vertical walls from the BOX layer to the surface of the handle layer. Therefore, it is possible to obtain the power generation output as designed, and it is possible to take out a larger amount of power even under vibration conditions with small acceleration from the outside.

As an example, in vibration-driven energy harvesting elements having the same comb teeth structure, the generated powers are compared with each other for the aspect ratio in the gap region having the gap dimension G1 shown in Fig. 5 being 7.1 and for the aspect ratio being 33.1. In the case of the vibration-driven energy harvesting element with the aspect ratio of 7.1, the comb tooth electrodes have G1 = 14 µm and L1 = 100 µm, and under a condition that the load resistance is 7 MΩ (optimal load connection), the resonance frequency is 125 Hz and the acceleration is 0.05 G, the generated power thus obtained is 68 µW. In the case of the vibration-driven energy harvesting element with the aspect ratio of 33.1, the comb tooth electrodes have G1 = 9 µm and L1 = 300 µm, and under a condition that the load resistance is 5 MΩ (optimal load connection), the resonance frequency is 139 Hz, and the acceleration is 0.20 G, the generated power thus obtained is 435 µW. That is, by setting the larger aspect ratio, the generated power can be increased by 6.4 times.

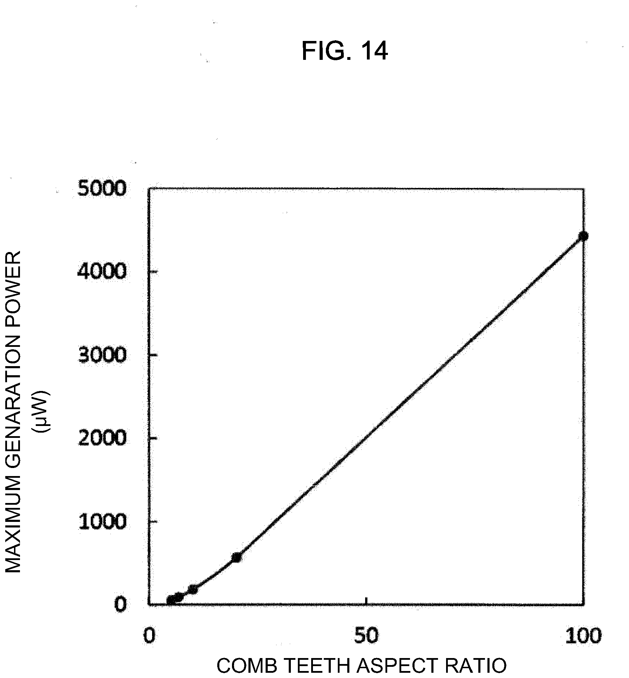

Fig. 14 is a graph showing an example of the relationship between the comb tooth aspect ratio and the generated power at the time of maximum displacement (optimal load connection). The maximum generated powers are shown when the comb tooth height L1 is fixed at 100 µm and the gap dimension G1 is set to 20 µm, 15 µm, 10 µm, 5 µm, and 1 µm. In each case, in the vibration-driven energy harvesting element 1, the number of comb teeth, the charging voltage, the maximum displacement of the movable electrode portion 121, and the like are set to be the same.
(1) As described above, the manufacturing method of a comb tooth element according to the present embodiment is a manufacturing method of the comb tooth element (that is, the vibration-driven energy harvesting element 1) that has a plurality of the fixed side comb tooth electrodes 110 and a plurality of the movable side comb tooth electrodes 120 arranged to interdigitate with each other through a clearance of the gap dimension G1, and an interdigitating amount of the comb tooth electrodes 120 with respect to the comb tooth electrodes 110 is variable, as shown in Fig. 5. Further, as shown in Fig. 9 (a), the patterned aluminum masks 404 for forming the comb tooth electrodes 110 and the patterned aluminum masks 405 for forming the comb tooth electrodes 120 are formed on the surface of the device layer 403 that is a base material to be etched. The patterned dummies 406 are formed as patterned masks to be etched, that are arranged on the device layer 403 between adjacent patterned aluminum masks 404 and between adjacent patterned aluminum masks 405 and have a thickness based on the gap dimension G1 between the comb tooth electrode 110 and the adjacent comb tooth electrode 120 and the gap dimension G2 between the adjacent comb tooth electrodes 110. The comb tooth electrodes 110 and the comb tooth electrodes 120 are formed by etching with the Deep-RIE the device layer 403 and the patterned dummies 406.

The patterned dummy 406 is arranged on the opening with a larger gap dimension, i.e., on the device layer 403 between the adjacent patterned aluminum masks 404 and between the adjacent patterned aluminum masks 405. Thereby, for both a portion where the gap dimension G1 is small and the aspect ratio is large as in the region where the comb tooth electrodes 110 and 120 are interdigitated with each other and a portion where the gap dimension G2 is large and the aspect ratio is small as in the root region of the comb tooth electrodes 110 and 120, the etching can reach the BOX layer 402, which is the etching stop layer, at substantially the same timing as shown in Fig. 11 (b). As a result, it is possible to prevent the groove wall portion from being etched in a notch shape, as shown by the sign C in Fig. 7 (b), in the root region (gap dimension G2) of the comb tooth electrodes 110 and 120, and thereby it is possible to form a comb tooth electrode having a shape as designed.

By adopting such a manufacturing method, it is possible to easily form the comb tooth electrodes 110 and 120 having a gap dimension G1 less than 10 µm and an aspect ratio of 30 or more. As a result, it is possible to increase the generated power as compared with the conventional type while suppressing the increase in size of the vibration-driven energy harvesting element 1.

(2) The thickness of the patterned dummy 406 as the patterned mask to be etched is calculated by a formula of (1 / Re1 - 1 / Re2) × Rer × L, where: Re1 is the etching rate for etching the device layer 403 with the Deep-RIE through the opening having the opening width of the gap dimension G1; Re2 is the etching rate for etching the device layer 403 with the Deep-RIE through the opening having the opening width of the gap dimension G2; Rer is the etching rate for etching the dummy pattern 406 with the Deep-RIE through the opening having the opening width of the gap dimension G2; and L is a comb tooth height of the comb tooth electrodes 110 and 120.

That is, the above-described thickness based on the gap dimensions G1 and G2 corresponds to the thickness of the patterned dummy 406 which is etched for a period of time difference between the time required for etching the device layer 403 in the region of the gap dimension G1 and the time required for etching the device layer 403 in the region of the gap dimension G2.

In the above-described embodiment, a SiO₂ film containing negative charged (SiO―) ions as a permanent charge is formed and electretized on the surface of the comb tooth electrodes 110 of the fixed electrode portion 111. However, a thermal oxide film (silicon oxide film) containing a permanent charge may be formed on a surface of at least either the comb tooth electrodes 110 or 120. Since this thermal oxide film is formed by thermally oxidizing the silicon which is a base material of the comb tooth electrodes 110 and 120, a uniform silicon oxide film can be formed on the entire surface of the comb tooth electrodes 110 and 120 even in a case where the aspect ratio is large.

(3) Furthermore, in a case where an electret is formed on at least either the comb tooth electrodes 110 or 120, by forming an electret protective film 500 (see Fig. 3) on the surface of the electret, the charge stability of the electret can be improved. As the electret protective film 500, for example, a protective film of aluminum oxide deposited by the Atomic Layer Deposition Method can be used. By using the ALD method, it is possible to achieve uniform film forming property even on the surface of a structure having a large aspect ratio such as the gap region of the comb tooth electrodes according to the present embodiment. Therefore, even for the comb tooth electrodes 110 and 120 having a large aspect ratio in the gap region, the protective film can be uniformly formed on the entire surface of the electret.

Although various embodiments and variations have been described above, the present invention is not limited to these contents. Other aspects that are conceivable within the scope of the technical idea of the present invention are also included within the scope of the present invention. For example, in the above-described embodiment, the comb tooth element has been exemplified by the vibration-driven energy harvesting element, however it can also be applied to an acceleration sensor or the like having a comb tooth structure. Here, the acceleration sensor of the comb tooth structure is a comb tooth element that has a plurality of fixed comb teeth and a plurality of movable comb teeth arranged to interdigitate with each other through a clearance, and an interdigitating amount of the movable comb teeth with respect to the fixed comb teeth changes according to acceleration.

The disclosure of the following priority application is herein incorporated by reference: Japanese Patent Application No. 2018-215631 filed November 16, 2018.

### REFERENCE SIGNS LIST

1 ... Vibration-driven Energy Harvesting Element, 11 ... Fixed Portion, 12 ... Movable Portion, 13 ... Elastic Support Portion, 110, 120 ... Comb tooth Electrode, 111 ... Fixed Electrode Portion, 121 ... Movable Electrode Portion, G1, G2 ... Gap Dimension, GA ... Clearance Region (Gap Region)

## Claims

1. A manufacturing method of a comb tooth element that has a plurality of fixed comb teeth and a plurality of movable comb teeth arranged to interdigitate with each other through a clearance, wherein an interdigitating amount of the movable comb teeth with respect to the fixed comb teeth is variable, the method comprising:
forming first patterned masks for forming the fixed comb teeth and second patterned masks for forming the movable comb teeth on a surface of a base material to be etched;
forming patterned masks to be etched, that are arranged on the base material to be etched between adjacent first patterned masks and between adjacent second patterned masks and have a thickness based on a first gap dimension between the fixed comb tooth and the movable comb tooth adjacent to one another and a second gap dimension between the fixed comb teeth adjacent to each other; and
forming the fixed comb teeth and the movable comb teeth by etching with Deep-RIE the base material to be etched and the patterned masks to be etched.

2. The manufacturing method of a comb tooth element according to claim 1, wherein:
the thickness of the patterned masks to be etched is calculated by a formula of (1 / Re1 - 1 / Re2) × Rer × L, where:
Re1 is an etching rate for etching the base material to be etched with the Deep-RIE through an opening having an opening width of the first gap dimension;
Re2 is an etching rate for etching the base material to be etched with the Deep-RIE through an opening having an opening width of the second gap dimension;
Rer is an etching rate for etching the patterned masks to be etched with the Deep-RIE through an opening having an opening width of the second gap dimension; and
L is a comb tooth height of the fixed comb teeth and the movable comb teeth.

3. The manufacturing method of a comb tooth element according to claim 1 or claim 2, further comprising:
after forming the fixed comb teeth and the movable comb teeth by etching with the Deep-RIE, forming an electret at least either at the fixed comb teeth or at the movable comb teeth.

4. The manufacturing method of a comb tooth element according to claim 3, further comprising:
after forming the electret, forming an electret protective film on a surface of the electret.
